# EUROPÄISCHE PATENTSCHRIFT

(11) **EP 1 661 191 B1**
(45) Veröffentlichungstag und Bekanntmachung des Hinweises auf die Patenterteilung: **17.12.2008**
(21) Anmeldenummer: 04764854.8
(22) Anmeldetag: 04.09.2004
(51) Int. Cl.: H01L 51/00

(54) **ELEKTRONISCHE VORRICHTUNGEN ENTHALTEND EINEN ORGANISCHEN LEITER UND HALBLEITER UND DAZWISCHEN EINE PUFFERSCHICHT AUS EINEM VERNETZTEN POLYMER**
ELECTRONIC DEVICES COMPRISING AN ORGANIC CONDUCTOR AND SEMICONDUCTOR AS WELL AS AN INTERMEDIATE BUFFER LAYER MADE OF A CROSSLINKED POLYMER
DISPOSITIFS ELECTRONIQUES CONTENANT UN CONDUCTEUR ET UN SEMI-CONDUCTEUR ORGANIQUES ET UNE COUCHE TAMPON EN POLYMERE RETICULE ENTRE LES DEUX

(30) Priorität: 04.09.2003 DE 10340711
(43) Veröffentlichungstag der Anmeldung: 31.05.2006
(73) Patentinhaber: Merck Patent GmbH, 64293 Darmstadt (DE)
(72) Erfinder: MÜLLER, David, Christoph, 80805 München (DE); RIEGEL, Nina, 50674 Köln (DE); MEERHOLZ, Klaus, 51503 Rösrath (DE); MEYER, Frank, 69120 Heidelberg (DE); SCHEURICH, Rene, 64846 Gross-Zimmern (DE); LUDEMANN, Aurelie, 60322 Frankfurt/Main (DE)
(86) Internationale Anmeldenummer: PCT/EP2004/009903
(87) Internationale Veröffentlichungsnummer: WO 2005/024971

(56) Entgegenhaltungen:
- EP-A- 0 637 899
- WO-A-02/10129
- US-A- 4 720 432
- CHANG S-C ET AL: "MULTICOLOR ORGANIC LIGHT-EMITTING DIODES PROCESSED BY HYBRID INKJETPRINTING" ADVANCED MATERIALS, VCH VERLAGSGESELLSCHAFT, WEINHEIM, DE, Bd. 11, Nr. 9, 5. Juli 1999 (1999-07-05), Seiten 734-737, XP000851832 ISSN: 0935-9648
- BERNIUS M ET AL: "FLUORENE-BASED POLYMERS-PREPARATION AND APPLICATIONS" JOURNAL OF MATERIALS SCIENCE. MATERIALS IN ELECTRONICS, CHAPMAN AND HALL, LONDON, GB, Bd. 11, Nr. 2, März 2000 (2000-03), Seiten 111-116, XP001012501 ISSN: 0957-4522
- BRAIG T: "Crosslinkable hole-transporting polymers by palladium catalyzed C-N-coupling reaction" MACROMOLECULAR: RAPID COMMUNICATIONS, WILEY VCH, WEINHEIM, DE, Bd. 21, Nr. 9, Juni 2000 (2000-06), Seiten 583-589, XP002193425 ISSN: 1022-1336

## Beschreibung

Elektronische Vorrichtungen, welche organische, metallorganische und/oder polymere Halbleiter enthalten, werden immer häufiger in kommerziellen Produkten verwendet oder stehen kurz vor der Markteinführung. Als Beispiele seien hier Ladungstransportmaterialien auf organischer Basis (i. d. R. Lochtransporter auf Triarylaminbasis) in Kopiergeräten und organische oder polymere Leuchtdioden (OLEDs oder PLEDs) in Anzeige- und Display-Vorrichtungen genannt. Organische Solarzellen (O-SC), organische Feldeffekt-Transistoren (O-FET), organische Dünnfilmtransistoren (O-TFT), organische Schaltelemente (O-IC), organische optische Verstärker oder organische Laserdioden (O-Laser) sind in einem Forschungsstadium weit fortgeschritten und könnten in der Zukunft große Bedeutung erlangen.

Viele dieser Vorrichtungen weisen nun, unabhängig vom Verwendungszweck, folgenden allgemeinen Schichtaufbau auf, der für die einzelnen Anwendungen entsprechend angepasst wird:
(1) Substrat
(2) Elektrode, häufig metallisch oder anorganisch, aber auch aus organischen bzw. polymeren leitfähigen Materialien
(3) Ladungsinjektionsschicht bzw. Zwischenschicht zum Ausgleich von Unebenheiten der Elektrode ("Planarisation Layer"), häufig aus einem leitfähigen, dotierten Polymer
(4) Organischer Halbleiter
(5) Eventuell Isolierschicht
(6) Zweite Elektrode, Materialien wie unter (2) genannt
(7) Verschaltung
(8) Verkapselung.

Ein Vorteil, den viele dieser organischen Vorrichtungen, v. a. solche, welche auf polymeren Halbleiter basieren, besitzen, ist, dass diese aus Lösung hergestellt werden können, was mit geringerem technischen und Ressourcenaufwand verbunden ist als Vakuumprozesse, wie sie im Allgemeinen für niedermolekulare Verbindungen durchgeführt werden. Für Vollfarbdisplays müssen die drei Grundfarben (rot, grün, blau) in einzelnen Pixels (Bildpunkten) mit hoher Auflösung nebeneinander aufgebracht werden. Analoges gilt für elektronische Schaltkreise mit unterschiedlichen Schaltelementen. Während bei niedermolekularen aufdampfbaren Molekülen die einzelnen Bildpunkte durch das Aufdampfen der einzelnen Farben durch Schattenmasken erzeugt werden können, ist dies für polymere und aus Lösung verarbeitete Materialien nicht möglich. Hier besteht ein Ausweg darin, die aktive Schicht (beispielsweise die Licht emittierende Schicht in OLEDs/PLEDs; Analoges gilt für Laser bzw. Ladungstrarnsportschichten in allen Anwendungen) direkt strukturiert aufzubringen. In letzter Zeit wurden hierfür insbesondere verschiedene Drucktechniken in Erwägung gezogen, wie beispielsweise Tintenstrahldruck (z. B. EP 0880303), Off-Set-Druck, etc.. Insbesondere an der Entwicklung von Tintenstrahldruckverfahren wird derzeit intensiv gearbeitet, und hier wurden in letzter Zeit erhebliche Fortschritte erzielt, so dass in nächster Zeit die ersten so hergestellten kommerziellen Produkte erwartet werden können.

In Vorrichtungen für die organische Elektronik wird häufig zwischen die Elektrode (insbesondere die Anode) und den organischen Halbleiter eine Zwischenschicht aus einem leitfähigen, dotierten Polymer eingebracht, die als Ladungsinjektionsschicht fungiert (Appl. Phys. Left. 1997, 70, 2067-2069). Die geläufigsten dieser Polymere sind Polythiophenderivate (z. B. Poly(3,4-ethylendioxy-2,5-thiophen), PEDOT) und Polyanilin (PANI), die in der Regel mit Polystryrolsulfonsäure oder anderen polymergebundenen Brönsted-Säuren dotiert und so in einen leitfähigen Zustand gebracht werden. Ohne in der nachfolgenden Erfindung an die Richtigkeit dieser speziellen Theorie gebunden sein zu wollen, vermuten wir, dass aus den sauren Gruppen bei Betreiben der Vorrichtung Protonen oder andere Verunreinigungen in die funktionelle Schicht diffundieren, die im Verdacht stehen, dort die Funktionalität der Vorrichtung bedeutend zu stören. So wird vermutet, dass diese Verunreinigungen die Effizienz wie auch die Lebensdauer der Vorrichtungen reduzieren.

Neuere Ergebnisse (M. Leadbeater, N. Patel, B. Tiemey, S. O'Connor, I. Grizzi, C. Towns, Book of Abstracts, SID Seattle, 2004) zeigen, dass das Einbringen einer lochleitenden Pufferschicht zwischen die Ladungsinjektionsschicht aus einem leitfähigen dotierten Polymer und den organischen Halbleiter in deutlich verbesserten Device-Eigenschaften, insbesondere in einer deutlich erhöhten Lebensdauer resultiert. In der Praxis geht man dabei bislang im Allgemeinen so vor, dass diese Pufferschicht durch ein Flächenbeschichtungsverfahren aufgebracht und anschließend getempert wird. Dabei wählt man idealerweise ein Material für die Pufferschicht, dessen Glasübergangtemperatur unter der des leitfähigen dotierten Polymers liegt, und tempert bei einer Temperatur oberhalb der Glastemperatur der Pufferschicht, jedoch unterhalb der Glastemperatur des leitfähigen dotierten Polymers, um dieses durch den Tempervorgang nicht zu schädigen. Dadurch wird in der Regel ein dünner Teil der Pufferschicht unlöslich, im Allgemeinen in der Größenordnung von 1 bis 25 nm. Für eine relativ geringe Glasübergangstemperatur der Pufferschicht wird ein Material mit einem relativ niedrigen Molekulargewicht benötigt. Ein solches Material lässt sich jedoch nicht durch Tintenstrahldruck aufbringen, da für gute Druckeigenschaften das Molekulargewicht höher liegen sollte.
Durch Aufbringen des organischen Halbleiters durch Spin-coating wird der lösliche Teil der Pufferschicht dann abgespült und die organische Halbleiterschicht auf dem unlöslichen Teil der Pufferschicht erzeugt. So kann hier relativ leicht eine Mehrschichtstruktur erzeugt werden. Das Aufbringen des organischen Halbleiters auf die Pufferschicht durch ein Druckverfahren ist so jedoch nicht möglich, da durch das Lösemittel dann der lösliche Teil der Pufferschicht angelöst wird und ein Blend aus dem Material der Pufferschicht und dem organischen Halbleiter entsteht. Die Herstellung von strukturierten Mehrschichtdevices ist so also nicht möglich.
Die Herstellung eines Devices mit Pufferschicht nur durch Tintenstrahldruck ist also bisher noch nicht möglich, da einerseits die Pufferschicht wegen des niedrigen Molekulargewichts nicht durch Drucktechniken aufgebracht werden kann und da andererseits die Lösung des organischen Halbleiters beim Aufbringen durch Drucktechniken die Pufferschicht teilweise löst. Da Drucktechniken, insbesondere Tintenstrahldruck, jedoch als eine sehr wichtige Methode zur Herstellung strukturierter Vorrichtungen gelten, andererseits aber auch die Verwendung von Pufferschichten viel Potenzial für weitere Entwicklungen aufweist, besteht hier also noch deutlicher Verbesserungsbedarf.

In EP 0637899 werden elektrolumineszierende Anordnungen mit einer oder mehreren Schichten vorgeschlagen, in denen mindestens eine Schicht vernetzt ist, die außerdem mindestens eine Emitterschicht enthalten und pro Schicht mindestens eine Ladungstransporteinheit. Dabei kann die Vernetzung radikalisch, anionisch, kationisch oder über eine photoinduzierte Ringschlussreaktion ablaufen. So können mehrere Schichten übereinander aufgebaut werden und die Schichten können auch strahlungsinduziert strukturiert werden. Es wird jedoch keine Lehre erteilt, durch welche der vielfältigen Vernetzungsreaktionen ein taugliches Device hergestellt werden kann und wie die Vernetzungsreaktion am besten durchgeführt wird. Es wird lediglich erwähnt, dass radikalisch vernetzbare Einheiten bzw. zur Photocycloaddition befähigte Gruppen bevorzugt sind, dass Hilfsstoffe verschiedener Art, wie beispielsweise Initiatoren, enthalten sein können und dass der Film bevorzugt mittels aktinischer Strahlung vernetzt wird. Auch geeignete Device-Konfigurationen sind nicht beschrieben. So ist nicht klar, wie viele Schichten das Device bevorzugt aufweist, wie dick diese sein sollen, welche Materialklassen bevorzugt involviert sind und welche davon vernetzt werden sollen. Daher ist es auch für den Fachmann nicht nachvollziehbar, wie die beschriebene Erfindung erfolgreich in die Praxis umgesetzt werden kann.

In ChemPhysChem 2000, 207 wird eine über Oxetangruppen vernetzte Triarylamin-Schicht auf Basis niedermolekularer Verbindungen als Zwischenschicht zwischen einem leitfähigen dotierten Polymer und einem organischen lumineszierenden Halbleiter beschrieben. Dabei wurde eine höhere Effizienz erhalten. Ein solches Device kann nicht durch Druckverfahren, insbesondere Tintenstrahldruck, hergestellt werden, da die niedermolekularen Triarylaminderivate vor der Vernetzung keine ausreichend viskosen Lösungen ergeben.

Überraschend wurde nun gefunden, dass die elektronischen Eigenschaften der Vorrichtungen deutlich verbessert werden können, wenn zwischen das leitfähige dotierte Polymer und die organische Halbleiterschicht mindestens eine kationisch *vernetzbare polymere Pufferschicht* eingebracht wird. Besonders gute Eigenschaften werden erhalten bei einer Pufferschicht, deren Vernetzung thermisch induziert wird, d. h. durch Temperaturerhöhung auf 50 - 250 °C. Die Vernetzung kann aber auch beispielsweise unter Zusatz einer Photosäure durch Bestrahlung initiiert werden. Außerdem kann eine solche Pufferschicht auch vorteilhaft durch Drucktechniken, insbesondere Tintenstrahldruck, aufgebracht werden, da hier die ideale Temperatur für die thermische Behandlung unabhängig von der Glasübergangstemperatur des Materials ist. Dadurch ist man nicht auf Materialien mit niedrigem Molekulargewicht angewiesen, was wiederum die Aufbringung der Schicht durch Drucktechniken ermöglicht. Da die Pufferschicht durch die Vernetzung unlöslich wird, kann auch die folgende Schicht (die organische Halbleiterschicht) durch verschiedene Drucktechniken, insbesondere Tintenstrahldruck, aufgebracht werden, weil hier dann nicht die Gefahr des Anlösens der Pufferschicht und der Blendbildung besteht.

Gegenstand der Erfindung sind daher organische elektronische Vorrichtungen, enthaltend Kathode, Anode, mindestens eine Schicht eines leitfähigen, dotierten Polymers und mindestens eine Schicht eines organischen Halbleiters, wobei als leitfähiges dotiertes Polymer durch Säuren dotierte Derivate von Polythiophen oder Polyanilin verwendet werden, dadurch gekennzeichnet, dass zwischen das dotierte Polymer und den organischen Halbleiter mindestens eine leitende oder halbleitende kationisch vernetzte polymere Pufferschicht eingebracht ist.

Bevorzugt ist der halbleitenden polymeren Pufferschicht zur Vernetzung weniger als 3 Gew.% einer Photosäure zugemischt, besonders bevorzugt weniger als 1 Gew.%, ganz besonders bevorzugt ist keine Photosäure zugemischt.

Weiterhin bevorzugt ist eine polymere vernetzbare Pufferschicht, deren Vernetzung in der entsprechenden Device-Anordnung thermisch, d. h. durch Temperaturerhöhung ohne Zusatz weiterer Hilfsstoffe, wie beispielsweise Photosäuren, induziert werden kann.

Eine Photosäure ist eine Verbindung, die bei Bestrahlung mit aktinischer Strahlung durch photochemische Reaktion eine protische Säure freisetzt. Beispiele für Photosäuren sind 4-(Thio-phenoxyphenyl)-diphenylsulfoniuin hexafluoroantimonat, {4-[(2-Hydroxytetradecyl)-oxyl]-phenyl}-phenyliodonlum hexafluoroantimonat und andere, wie beispielsweise in EP 1308781 beschrieben. Die Photosäure kann für die Vernetzungsreaktion zugesetzt werden, wobei bevorzugt ein Anteil von ca. 0.5 bis 3 Gew.% gewählt wird, muss jedoch nicht notwendigerweise zugesetzt wenden.

Elektronische Vorrichtungen im Sinne dieser Erfindung sind organische oder polymere Leuchtdioden (OLEDs, PLEDs, z. B. EP 0 676 461, WO 98/27136), organische Solarzellen (O-SC, z. B. WO 98/48433, WO 94/05045), organische FeldEffekt-Transistoren (O-FET, z. B. US 5705826, US 5596208, WO 00142668), organische, Dünnfilmtransistoren (O-TFTs), organische Schaltelemente (O-IC, z. B. WO 95/31833, WO 99/10939), organische Feld-Quench-Elemente (FQD, z. B. US 2004/017148), organische optische Verstärker oder organische Laserdioden (O-Laser, z. B. WO 98/03566). Organisch im Sinne dieser Erfindung bedeutet, dass mindestens eine Schicht eines organischen leitfähigen dotierten Polymers, mindestens eine leitende oder halbleitende polymere Pufferschicht und mindestens eine Schicht enthaltend mindestens einen organischen Halbleiter vorhanden sind; es können auch weitere organische Schichten (beispielsweise Elektroden, etc.) vorhanden sein. Es können aber auch Schichten vorhanden sein, die nicht auf organischen Materialien basieren, wie beispielsweise weitere Zwischenschichten oder Elektroden.

Die elektronische Vorrichtung ist im einfachsten Fall aufgebaut aus Substrat (üblicherweise Glas oder Kunststofffolie), Elektrode, Zwischenschicht aus einem leitfähigen, dotierten Polymer, wobei als leitfähiges dotiertes Polymer durch Säuren dotierte Derivate von Polythiophen oder Polyanilin verwendet werden, erfindungsgemäße kationisch vernetzte Pufferschicht, organischer Halbleiter und Gegenelektrode. Diese Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt. Dabei kann es auch bevorzugt sein, als Elektrodenmaterial für eine oder beide Elektroden ein leitfähiges, dotiertes Polymer zu verwenden und keine Zwischenschicht aus leitfähigem, dotiertem Polymer einzubringen. Für Anwendungen in O-FETs und O-TFTs ist es außerdem erforderlich, dass der Aufbau außer Elektrode und Gegenelektrode (Source und Drain) noch eine weitere Elektrode (Gate) enthält, die durch eine Isolatorschicht mit einer in der Regel hohen (oder seltener niedrigen) Dielektrizitätskonstante vom organischen Halbleiter abgetrennt ist. Außerdem kann es sinnvoll sein, in die Vorrichtung noch weitere Schichten einzubringen.

Die Elektroden werden so gewählt, dass ihr Potenzial möglichst gut mit dem Potenzial der angrenzenden organischen Schicht übereinstimmt, um eine möglichst effiziente Elektronen- bzw. Lochinjektion zu gewährleisten. Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden.
Es kann auch bevorzugt sein, zwischen einer metallischen Kathode und dem organischen Halbleiter eine dünne Zwischenschicht eines Materials mit einer hohen Dielektrizitätskonstanten einzubringen. Hierfür kommen beispielsweise Alkalimetall- oder Erdalkalimetallfluoride, aber auch die entsprechenden -oxide in Frage (z. B. LiF, Li₂O, BaF₂, MgO, NaF, etc.). Die Schichtdicke dieser dielektrischen Schicht beträgt bevorzugt zwischen 1 und 10 nm.

Als Anode sind Materialien mit hoher Austrittsarbeit bevorzugt. Bevorzugt weist die Anode ein Potenzial größer 4.5 eV vs. Vakuum auf. Hierfür sind einerseits Metalle mit hohem Redoxpotential geeignet, wie beispielsweise Ag, Pt oder Au. Es können auch Metall/Metalloxid-Elektroden (z. B. Al/Ni/NiOₓ, Al/Pt/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Als Ladungsinjektionsschicht auf der Anode kommen verschiedene durch Säuren dotierte, leitfähige Derivate von Polythiophen (insbesondere Poly(3,4-ethylendioxy-2,5-thiophen), PEDOT) und Polyanilin (PANI) in Frage. Bevorzugt sind Polymere, die je nach Anwendung eine Leitfähigkeit von > 10⁻⁸ S/cm aufweisen. Das Potenzial der Schicht beträgt bevorzugt 4 bis 6 eV vs. Vakuum. Die Schichtdicke beträgt bevorzugt zwischen 10 und 500 nm, besonders bevorzugt zwischen 20 und 250 nm. Bevorzugt erfolgt die Dotierung durch polymergebundene Brönsted-Säuren. Besonders bevorzugt sind hierfür polymergebundene Sulfonsäuren, insbesondere Poly(styrolsulfonsäure), Poly(vinylsulfonsäure) und PAMPSA (Poly-(2-acrylamido-2-methyl-propansulfonsäure)). Das leitfähige Polymer wird in der Regel aus einer wässrigen Lösung oder Dispersion aufgetragen und ist unlöslich in organischen Lösungsmitteln. Dadurch kann die Folgeschicht aus organischen Lösungsmitteln problemlos aufgebracht werden.

Bevorzugt enthält der organische Halbleiter mindestens eine polymere Verbindung.
Es kann sich dabei um eine einzige polymere Verbindung oder um einen Blend aus zwei oder mehr polymeren Verbindungen oder um einen Blend einer oder mehrerer polymerer Verbindungen mit einer oder mehreren niedermolekularen organischen Verbindungen handeln. Die organische Halbleiterschicht kann bevorzugt durch verschiedene Druckverfahren, insbesondere durch Tintenstrahldruckverfahren, aufgebracht werden. Unter einem organischen Material im Sinne dieser Erfindung sollen nicht nur rein organische Verbindungen, sondern auch metallorganische Verbindungen und Metallkoordinationsverbindungen mit organischen Liganden verstanden werden. Bei lumineszierenden Verbindungen können diese entweder fluoreszieren oder phosphoreszieren, also aus dem Singulett- oder aus dem TriplettZustand Licht emittieren. Dabei können die polymeren Materialien konjugiert, teilkonjugiert oder nicht-konjugiert sein. Bevorzugt sind konjugierte Materialien. Konjugierte Polymere im Sinne dieser Erfindung sind Polymere, die in der Hauptkette hauptsächlich sp²-hybridisierte Kohlenstoffatome enthalten, die auch durch entsprechende Heteroatome ersetzt sein können. Des Weiteren wird in diesem Anmeldetext ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Typische Vertreter konjugierter Polymere, wie sie beispielsweise in PLEDs oder O-SCs verwendet werden können, sind Poly-para-phenylenvinylene (PPV), Polyfluorene, Poly-spirobifluorene, Poly-dihydrophenanthrene, Poly-indenofluorene, Systeme, die im weitesten Sinne auf Poly-p-phenylenen (PPP) basieren, und Derivate dieser Strukturen. Für die Verwendung in O-FETs sind vor allem Materialien mit hoher Ladungsträgermobilität von Interesse. Dies sind beispielsweise Oligo- oder Poly(triarylamine), Oligo- oder Poly(thiophene) und Copolymere, die einen hohen Anteil dieser Einheiten enthalten. Die Schichtdicke des organischen Halbleiters beträgt je nach Anwendung bevorzugt 10 - 500 nm, besonders bevorzugt 20 - 250 nm.

Ohne an eine bestimmte Theorie gebunden sein zu wollen, vermuten wir, dass die in dem leitfähigen dotierten Polymer enthaltenen Protonen oder andere kationische Verunreinigungen problematisch sind und deren Diffusion aus dem dotierten Polymer im Verdacht steht, begrenzend für die Lebensdauer der elektronischen Vorrichtung zu sein. Außerdem ist die Lochinjektion aus den dotierten Polymeren in den organischen Halbleiter oft nicht zufriedenstellend.

Daher wird eine polymere Pufferschicht zwischen das leitfähige, dotierte Polymer und den organischen Halbleiter eingebracht, die kationisch vernetzbare Einheiten trägt, so dass sie niedermolekulare, kationische Spezies sowie intrinsische kationische Ladungsträger aufnehmen kann, die aus dem leitfähigen, dotierten Polymer diffundieren können. Diese Schicht dient weiterhin einer verbesserten Lochinjektion und als Elektronenblockierschicht. Bevorzugt werden für die Pufferschicht konjugierte vernetzbare Polymere verwendet. Das Molekulargewicht der für die Pufferschicht verwendeten Polymere liegt vor der Vernetzung bevorzugt im Bereich von 50 bis 500 kg/mol, besonders bevorzugt im Bereich von 200 bis 250 g/mol. Dieser Molekulargewichtsbereich hat sich als besonders geeignet erwiesen für die Aufbringung durch Tintenstrahldruck. Für andere Drucktechniken können jedoch auch andere Molekulargewichtsbereiche bevorzugt sein. Die Schichtdicke der Pufferschicht liegt bevorzugt im Bereich von 1 bis 300 nm, besonders bevorzugt im Bereich von 15 bis 200 nm, ganz besonders bevorzugt im Bereich von 40 bis 100 nm. Bevorzugt liegt das Potenzial der Pufferschicht zwischen dem Potenzial des leitfähigen, dotierten Polymers und dem des organischen Halbleiters, um die Ladungsinjektion zu verbessern. Dies kann erreicht werden durch geeignete Wahl der Materialien für die Pufferschicht sowie geeignete Substitution der Materialien. Es kann auch bevorzugt sein, dem polymeren Material der Pufferschicht weitere vernetzbare niedermolekulare Verbindungen zuzumischen. Dies kann sinnvoll sein, um beispielsweise die Glasübergangtemperatur der Mischung zu reduzieren und damit eine Vernetzung bei geringerer Temperatur zu ermöglichen.

Bevorzugte Materialien für die Pufferschicht leiten sich ab von lochleitenden Materialien. Besonders bevorzugt eignen sich hierfür kationisch vernetzbare Materialien auf Triarylamin-Basis, auf Thiophen-Basis, auf Triarylphosphin-Basis oder Kombinationen dieser Systeme, wobei auch Copolymere daraus mit anderen Strukturen, beispielsweise Fluorenen, Spirobifluorenen, Dihydrophenanthrenen, Indenofluorenen, etc., geeignete Materialien darstellen, wenn ein ausreichend hoher Anteil der oben genannten lochleitenden Einheiten verwendet wird. Besonders bevorzugt beträgt der Anteil der lochleitenden Einheiten im Polymer mindestens 10 mol%. Durch geeignete Substitution können die Potenziale dieser Verbindungen eingestellt werden. So erhält man durch Einführung elektronenziehender Substituenten (z. B. F, Cl, CN, etc.) Verbindungen mit einem niedrigeren HOMO (= höchstes besetztes Molekülorbital), während durch elektronenschiebende Substituenten (z. B. Alkoxygruppen, Aminogruppen, etc.) ein höheres HOMO erreicht wird.

Ohne an eine bestimmte Theorie gebunden sein zu wollen, vermuten wir, dass eine kationisch vernetzbare Pufferschicht diffundierende kationische Spezies, insbesondere Protonen, aufnehmen kann, indem dadurch die Vernetzungsreaktion initiiert wird; andererseits wird durch die Vernetzung gleichzeitig die Pufferschicht unlöslich gemacht, so dass das anschließende Auftragen des organischen Halbleiters aus den üblichen organischen Lösungsmitteln keine Probleme bereitet. Die vernetzte Pufferschicht stellt eine weitere Barriere gegen Diffusion dar. Bevorzugte polymerisierbare Gruppen sind daher kationisch vernetzbare Gruppen, insbesondere:
1) elektronenreiche Olefinderivate,
2) heteronukleare Mehrfachbindungen mit Heteroatomen oder Heterogruppierungen und
3) Ringe mit Heteroatomen (z. B. O S, N, P, Si, etc.), die durch kationische ringöffnende Polymerisation (cationic ring-opening polymerisation) reagieren.

Elektronenreiche Olefinderivate und Verbindungen mit heteronuklearen Mehrfachbindungen mit Heteroatomen oder Heterogruppierungen sind bevorzugt solche, wie sie in H.-G. Elias, Makromoleküle, Band 1. Grundlagen: Struktur-Synthese - Eigenschaften, Hüthig & Wepf Verlag, Basel, 5. Auflage, 1990, S. 392 - 404, beschrieben sind, ohne dadurch die Vielfalt der möglichen Verbindungen einschränken zu wollen.

Bevorzugt sind organische Materialien, bei denen mindestens ein H-Atom durch eine Gruppe ersetzt ist, die durch kationische ringöffnende Polymerisation reagiert. Einen allgemeinen Überblick über die kationische ringöffnende Polymerisation gibt beispielsweise E. J. Goethals et al., "Cationic Ring Opening Polymerization" (New Methods Polym. Synth. 1992, 67-109). Allgemein eignen sich hierfür nichtaromatische cyclische Systeme, in denen ein oder mehrere Ringatome gleich oder verschieden O, S, N, P, Si, etc. sind. Bevorzugt sind hier cyclische Systeme mit 3 bis 7 Ringatomen, in denen 1 bis 3 Ringatome gleich oder verschieden O, S oder N sind. Beispiele für solche Systeme sind unsubstituierte oder substituierte cyclische Amine (z. B. Aziridin, Azeticin, Tetrahydropyrrol, Piperidin), cyclische Ether (z. B. Oxiran, Oxetan, Tetrahydrofuran, Pyran, Dioxan), ebenso wie die entsprechenden Schwefelderivate, cyclische Acetale (z. B. 1,3-Dioxolan, 1,3-Dioxepan, Trioxan), Lactone, cyclische Carbonate, aber auch cyclische Strukturen, die unterschiedliche Heteroatome im Cyclus enthalten (z. B. Oxazoline, Dihydrooxazine, Oxazolone). Bevorzugt sind weiterhin cyclische Siloxane mit 4 bis 8 Ringatomen.

Ganz besonders bevorzugt sind polymere organische Materialien, bei denen mindestens ein H-Atom durch eine Gruppe der Formel (I), Formel (II) oder Formel (III) ersetzt ist, 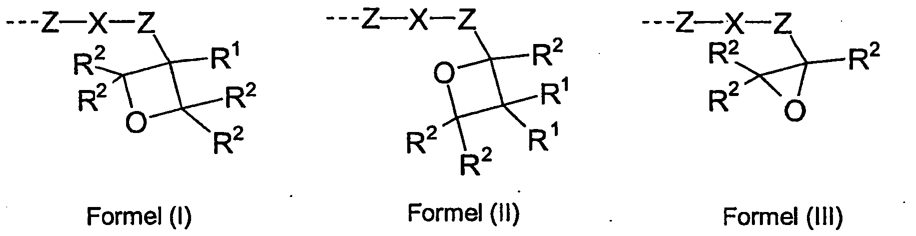 wobei gilt:
- R¹: ist bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, ein aromatisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R¹ miteinander bzw. mit R², R³ und/oder R⁴ ein mono- oder polycyclisches, aliphatisches oder aromatisches Ringsystem bilden;
- R²: ist bei jedem Auftreten gleich oder verschieden Wasserstoff, eine geradkettige, verzweigte oder cyclische Alkylgruppe mit 1 bis 20 C-Atomen, ein aromatisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R² miteinander bzw. mit R¹, R³ und/oder R⁴ ein mono- oder polycyclisches, aliphatisches oder aromatisches Ringsystem bilden;
- X: ist bei jedem Auftreten gleich oder verschieden -O-, -S-, -CO-, -COO-, -O-CO- oder eine bivalente Gruppe -(CR³R⁴)ₙ-;
- Z: ist bei jedem Auftreten gleich oder verschieden eine bivalente Gruppe -(CR³R⁴)ₙ-;
- R³, R⁴: ist bei jedem Auftreten gleich oder verschieden Wasserstoff, eine geradkettige, verzweigte oder cyclische Alkyl-, Alkoxy-, Alkoxyalkyl- oder Thioalkoxy-Gruppe mit 1 bis 20 C-Atomen, ein aromatisches oder heteroaromatisches Ringsystem mit 4 bis 24 aromatischen Ringatomen oder eine Alkenyl-Gruppe mit 2 bis 10 C-Atomen, bei denen ein oder mehrere Wasserstoffatome auch durch Halogen, wie Cl oder F, oder CN ersetzt sein können; dabei können auch zwei oder mehr Reste R³ bzw. R⁴ miteinander bzw. auch mit R¹ oder R² ein Ringsystem bilden;
- n: ist bei jedem Auftreten gleich oder verschieden eine ganze Zahl zwischen 0 und 20, bevorzugt zwischen 1 und 10, insbesondere zwischen 1 und 6;
mit der Maßgabe, dass die Anzahl dieser Gruppen gemäß Formel (I) bzw. Formel (II) bzw. Formel (III) durch die maximal verfügbaren, d. h. substituierbaren H-Atome begrenzt ist.

Die Vernetzung dieser Einheiten kann beispielsweise durch thermische Behandlung der Vorrichtung in diesem Stadium durchgeführt werden. Fakultativ kann auch eine Photosäure für die Vernetzung zugesetzt werden. Bevorzugt ist die thermische Vernetzung ohne Zusatz einer Photosäure. Ebenso können fakultativ weitere Hilfsstoffe zugesetzt werden, wie beispielsweise Salze oder Säuren, die sowohl zur Pufferschicht, wie auch zur leitfähigen Polymerschicht zugesetzt werden. Bevorzugt findet diese Vernetzung bei einer Temperatur von 80 bis 200 °C und einer Dauer von 0.1 bis 60 Minuten in einer inerten Atmosphäre statt. Besonders bevorzugt findet diese Vernetzung bei einer Temperatur von 100 bis 180 °C und einer Dauer von 1 bis 30 Minuten in einer inerten Atmosphäre statt.

Für die Herstellung der Vorrichtungen wird in der Regel folgendes allgemeine Verfahren angewandt, das entsprechend ohne weiteres erfinderisches Zutun für den Einzelfall anzupassen ist:
- Ein Substrat (z. B. Glas oder auch ein Kunststoff) wird mit der Anode beschichtet (beispielsweise Indium-Zinn-Oxid, ITO, etc.). Anschließend wird die Anode (z. B. photolithografisch) der gewünschten Anwendung gemäß strukturiert und verschaltet. Das mit der Anode beschichtete vorgereinigte Substrat wird mit Ozon oder mit Sauerstoffplasma behandelt oder kurze Zeit mit einer Excimer-Lampe bestrahlt.
- Anschließend wird ein leitfähiges dotiertes Polythiophen- (PEDOT) oder Polyanilinderivat (PANI) in einer dünnen Schicht auf das ITO-Substrat durch Spincoaten oder andere Beschichtungsverfahren aufgebracht.
- Auf diese Schicht wird die vernetzbare Pufferschicht aufgebracht. Die entsprechende Verbindung wird dazu zunächst in einem Lösemittel oder Lösemittelgemisch, bevorzugt unter Schutzgas, gelöst und filtriert. Als Lösemittel eignen sich aromatische Flüssigkeiten (z. B. Toluol, Xylole, Anisol, Chlorbenzol), cyclische Ether (z. B. Dioxan, Methyldioxan, THF) oder Amide (z. B. NMP, DMF), aber auch Lösemittelgemische, wie in WO 02/072714 beschrieben. Mit diesen Lösungen können die vorher beschriebenen Träger ganzflächig, z. B. durch Spin-Coat-Verfahren, oder strukturiert durch Druckverfahren, insbesondere Tintenstrahldruck, beschichtet werden. Die Vernetzung kann dann (bei Verwendung kationisch vernetzbarer Gruppen) erfolgen, indem das Device in diesem Stadium in einer inerten Atmosphäre erhitzt wird. Es kann auch eine Photosäure zugesetzt werden und die Vernetzung durch Bestrahlung initiiert werden, wodurch auch eine Strukturierung erzielt werden kann. Je nach Art der vernetzbaren Gruppe kann die Vernetzung auf unterschiedliche Weisen initiiert werden. Optional kann anschließend mit einem Lösungsmittel, beispielsweise THF, gespült werden. Abschließend wird getrocknet.
- Darauf bringt man eine Lösung eines organischen Halbleiters auf. Für die Herstellung strukturierter Vorrichtungen eignen sich hier insbesondere Druckverfahren, beispielsweise Tintenstrahldruck. Durch die Vernetzung der Pufferschicht ist das Aufbringen des organischen Halbleiters aus Lösung problemlos möglich, ohne dass die Pufferschicht dabei gelöst wird.
- Auf diese Polymerschichten können optional weitere funktionelle Schichten, wie beispielsweise Ladungsinjektions- oder -transportschichten oder Lochblockierschichten aufgebracht werden, z. B. aus Lösung, aber auch durch Aufdampfen.
- Anschließend wird eine Kathode aufgebracht. Dies erfolgt nach dem Stand der Technik durch einen Vakuumprozess und kann beispielsweise sowohl durch thermisches Bedampfen als auch durch Plasmaspritzen (Sputtern) geschehen.
- Da viele der Anwendungen empfindlich auf Wasser, Sauerstoff oder sonstige Bestandteile der Atmosphäre reagieren, ist eine effektive Einkapselung des Devices unerläßlich.
- Der oben beschriebene Aufbau wird für die einzelnen Anwendungen ohne weiteres erfinderisches Zutun entsprechend angepasst und optimiert und kann allgemein für verschiedene Anwendungen, wie organische und polymere Leuchtdioden, organische Solarzellen, organische Feldeffekttransistoren, organische Dünnfilmtransistoren, organische Schaltelemente, organische optische Verstärker oder organische Laserdioden verwendet werden.

Überraschend bietet diese vernetzbare Pufferschicht, die wischen das leitfähige, dotierte Polymer und den organischen Halbleiter eingebracht wird, folgende Vorteile:
1) Durch Einbringen der vernetzbaren Pufferschicht verbessern sich die optoelektronischen Eigenschaften der elektronischen Vorrichtung gegenüber einer Vorrichtung, die keine derartige Pufferschicht enthält. So beobachtet man eine höhere Effizienz und höhere Lebensdauer.
2) Durch die Vernetzung der Pufferschicht ist es möglich, dickere Pufferschichten zu erzeugen, als dies mit unvernetzten Pufferschichten möglich ist, die durch Tempern und Spülen nur eine dünne unlösliche Schicht bilden. Mit diesen dickeren, vernetzten Pufferschichten erhält man bessere Device-Ergebnisse als mit unvernetzten dünneren Pufferschichten gemäß dem Stand der Technik.
3) Durch die kationische Vernetzung der Pufferschicht ist man nicht auf eine niedrige Glasübergangtemperatur und somit nicht auf ein niedermolekulares Material zum Tempern angewiesen. Dadurch, dass hierfür jetzt auch hochmolekulare Materialien verwendet werden können, ist es möglich, die Pufferschicht durch Tintenstrahldruck aufzubringen.
4) Durch die Vernetzung der Pufferschicht erhält man eine unlösliche Schicht. Dadurch ist es möglich, die darauf folgende Schicht des organischen Halbleiters durch ein Druckverfahren, beispielsweise Tintenstrahldruck aufzubringen, ohne dass die Pufferschicht gelöst wird und sich ein Blend aus dem Material der Pufferschicht und dem organischen Halbleiter bildet. Dies ist mit Pufferschichten gemäß dem Stand der Technik nicht möglich, ist von großer Bedeutung für die Herstellung strukturierter Devices.

Die vorliegende Erfindung wird durch die folgenden Beispiele näher erläutert, ohne sie darauf einschränken zu wollen. In diesen Beispielen wird nur auf organische und polymere Leuchtdioden eingegangen. Der Fachmann kann jedoch aus den aufgeführten Beispielen ohne erfinderisches Zutun weitere elektronische Vorrichtungen darstellen, wie beispielsweise O-SC, O-FETs, O-TFTs, O-ICs, organische optische Verstärker und O-Laser, um nur einige weitere Anwendungen zu nennen.

### Beispiele

### Beispiel 1: Schichtdicke der vernetzbaren Pufferschicht

Eine 60 nm dicke Schicht der vernetzbaren Pufferschicht A (Polymer mit der Struktur A) wurden auf ein Device via Spin-Coating aufgetragen, welche folgenden Schichtaufbau aufwies: Glas//150 nm ITO//80 nm PEDOT (10 Min. bei 200 °C getempert). Anschließend wurde das Device 1 h bei 180 °C aufgeheizt. PEDOT ist ein Polythiophen-Derivat (Baytron P4083 von H. C. Starck, Goslar). Das Device wurde mit Toluol abgesponnen und die resultierende Schichtdicke gemessen. Für die Pufferschicht wurde eine Schichtdicke von 60 nm (± 2 nm) bestimmt.

### Beispiel 2 (Vergleich): Schichtdicke der nicht vernetzbaren Pufferschicht

Eine 60 nm dicke Schicht der nicht vernetzbaren Pufferschicht B (Polymer mit der Struktur B) wurden auf ein Device via Spin-Coating aufgetragen, welche folgenden Schichtaufbau aufwies: Glas//150 nm ITO//80 nm PEDOT (10 Min. bei 200 °C getempert). Anschließend wurde das Device 1 h bei 180 °C ausgeheizt.
Das Device wurde mit Toluol abgesponnen und die resultierende Schichtdicke gemessen. Für die Pufferschicht wurde eine Schichtdicke von 10 nm (± 1 nm) bestimmt.

### Beispiel 3: OLED mit vernetzbarer Pufferschicht

Auf das Device mit 60 nm Pufferschicht A wurden 80 nm des blau emittieren Polymers C aufgesponnen. Die gemessene Gesamtschichtdicke (PEDOT + Pufferschicht + emittierendes Polymer) betrug 220 nm (± 4 nm). Als Kathode wurde in allen Fällen Ba von der Firma Aldrich und Ag von der Firma Aldrich verwendet. Wie PLEDs allgemein dargestellt werden können, ist beispielsweise in WO 04/037887 und der darin zitierten Literatur ausführlich beschrieben.

Für das Device wurde eine maximale Effizienz von 4.1 cd/A und eine Lebensdauer von 640 h (beginnend von 800 cd/m²) gemessen.

### Beispiel 4 (Vergleich): OLED mit nicht vernetzbarer Pufferschicht

Auf das Device mit 60 nm Pufferschicht B (nicht mit Toluol gespült) wurden 80 nm des blau emittieren Polymers C aufgesponnen. Die gemessene Gesamtschichtdicke (PEDOT + Pufferschicht + emittierendes Polymer) betrug 170 nm (± 3 nm).
Für das Device wurde eine maximale Effizienz von 3.5 cd/A und eine Lebensdauer von 420 h (beginnend von 800 cd/m²) gemessen.

### Beispiel 5 (Vergleich): OLED ohne Pufferschicht

Auf ein Device bestehend aus Glas/11 50 nm ITO//80 nm PEDOT (10 Min. bei 200 °C getempert) wurden 80 nm des blau emittieren Polymers C aufgesponnen. Die gemessene Gesamtschichtdicke (PEDOT + Pufferschicht + emittierendes Polymer) betrug 160 nm (± 3 nm).
Für das Device wurde eine maximale Effizienz von 3.1 cd/A und eine Lebensdauer von 180 h (beginnend von 800 cd/tm²) gemessen.

Die Polymere A, B und C und die entsprechenden Monomere wurden gemäß WO 02/10129, WO 03/020790 und WO 03/048225 synthetisiert. Die Zusammensetzungen und Strukturen der Polymere A, B und C sind im Folgenden der Übersichtlichkeit halber abgebildet

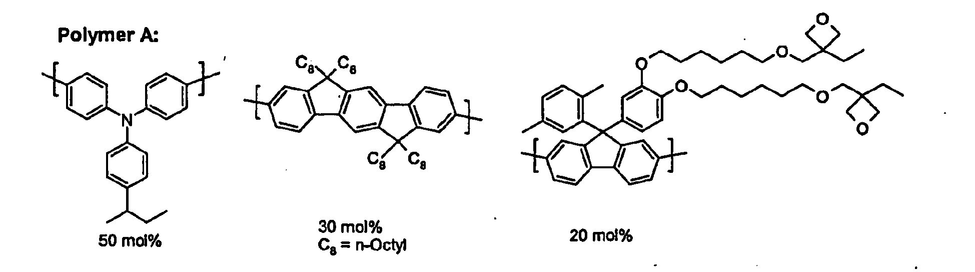

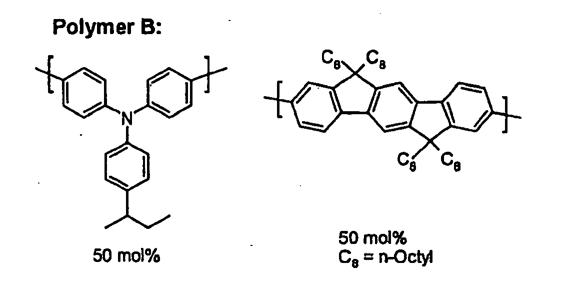

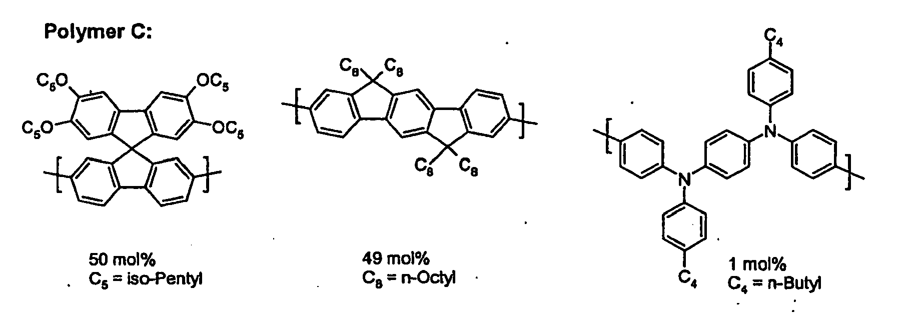

Wie man also aus Beispiel 1 und dem Vergleichsbeispiel 2 sieht, ist es mit der vernetzbaren Pufferschicht möglich, dickere unlösliche Schichten zu erzeugen, auf die dann das lichtemittierende Polymer aufgetragen werden kann. Insbesondere ist auch auch möglich, das Polymer C auf das vernetzte Polymer A durch Drucktechniken aufzutragen, da sich dieses durch Lösemittel nicht mehr löst, während es nicht möglich ist, das Polymer C auf das unvemetzte Polymer B aufzutragen, da dieses dadurch gelöst wird.
Ebenso sieht man aus Beispiel 3 und dem Vergleichsbeispiel 4, dass das Polymer C eine höhere Effizienz und eine längere Lebensdauer zeigt, wenn es mit Pufferschicht verwendet wird, im Gegensatz zum Vergleichsbeispiel 5, in dem es ohne Pufferschicht direkt auf PEDOT aufgetragen wurde. Dabei fällt auf, dass die Verwendung einer vernetzbaren Pufferschicht zu deutlich besseren Ergebnissen (höhere Effizienz, längere Lebensdauer) führt als die Verwendung der nicht vernetzbaren Pufferschicht.

## Patentansprüche

1. Organische elektronische Vorrichtung, enthaltend Kathode, Anode, mindestens eine Schicht eines leitfähigen, dotierten Polymers und mindestens eine Schicht eines organischen Halbleiters, wobei als leitfähiges dotiertes Polymer durch Säuren dotierte Derivate von Polythiophen oder Polyanilin verwendet werden, **dadurch gekennzeichnet, dass** zwischen das dotierte Polymer und den organischen Halbleiter mindestens eine leitende oder halbleitende kationisch vernetzte polymere Pufferschicht eingebracht ist.

2. Organische elektronische Vorrichtung gemäß Anspruch 1, **dadurch gekennzeichnet, dass** es sich um organische oder polymere Leuchtdioden (OLED, PLED), organische Solarzellen (O-SC), organische Feld-Effekt-Transistoren (O-FET), organische Dünnfilmtransistoren (O-TFT), organische Schaltelemente (O-IC), organische Feld-Quench-Elemente (FQD), organische optische Verstärker oder organische Laserdioden (O-Laser) handelt.

3. Organische elektronische Vorrichtung gemäß Anspruch 1 und/oder 2, **dadurch gekennzeichnet, dass** der organische Halbleiter mindestens eine polymere Verbindung enthält.

4. Organische elektronische Vorrichtung gemäß Anspruch 3, **dadurch gekennzeichnet, dass** es sich bei der polymeren Verbindung um ein konjugiertes Polymer handelt.

5. Organische elektronische Vorrichtung gemäß Anspruch 4, **dadurch gekennzeichnet, dass** als organische Halbleiter konjugierte Polymere aus den Klassen der Poly-para-phenylenvinylene (PPV), Polyfluorene, Poly-spirobifluorene, Poly-dihydrophenanthrene, Poly-indenofluorene, Systeme, die im weitesten Sinne auf Poly-p-phenylenen (PPP) basieren, und Derivate dieser Strukturen eingesetzt werden.

6. Organische elektronische Vorrichtung gemäß einem oder mehreren der Ansprüche 1 bis 5, **dadurch gekennzeichnet, dass** die polymere vernetzte Pufferschicht vor der Vernetzung ein Molekulargewicht im Bereich von 50 bis 500 kg/mol aufweist.

7. Organische elektronische Vorrichtung gemäß einem oder mehreren der Ansprüche 1 bis 6, **dadurch gekennzeichnet, dass** die Schichtdicke der polymeren vernetzten Pufferschicht im Bereich von 1 bis 300 nm liegt.

8. Organische elektronische Vorrichtung gemäß einem oder mehreren der Ansprüche 1 bis 7, **dadurch gekennzeichnet, dass** die Pufferschicht aus einem konjugierten Polymer aufgebaut ist.

9. Organische elektronische Vorrichtung gemäß einem oder mehreren der Ansprüche 1 bis 8, **dadurch gekennzeichnet, dass** die Materialien der Pufferschicht Triarylamin-, Thiophen- oder Triarylphosphin-Polymere oder Kombinationen dieser Systeme sind.

10. Organische elektronische Vorrichtung gemäß einem oder mehreren der Ansprüche 1 bis 9, **dadurch gekennzeichnet dass** die Materialien der Pufferschicht Copolymere aus Triarylamin-, Thiophen- und/oder Triarylphosphin-Derivaten mit Fluorenen, Spirobifluorenen, Dihydrophenanthrenen und/oder Indenofluorenen sind.

11. Organische elektronische Vorrichtung gemäß Anspruch 1, **dadurch gekennzeichnet, dass** die vernetzbaren Gruppen ausgewählt sind aus elektronenreichen Olefinderivaten, heteronuklearen Mehrfachbindungen mit Heteroatomen oder Heterogruppierungen oder Ringen mit Heteroatomen, die durch kationische ringöffnende Polymerisation reagieren.

12. Organische elektronische Vorrichtung gemäß Anspruch 11, **dadurch gekennzeichnet, dass** in den Materialien der Pufferschicht mindestens ein H-Atom durch eine durch kationische ringöffnende Polymerisation reagierende heterocyclische Verbindung ersetzt ist. ,

13. Organische elektronische Vorrichtung gemäß Anspruch 12, **dadurch gekennzeichnet, dass** in den Materialien der Pufferschicht mindestens ein H-Atom durch eine Gruppe der Formel (I), Formel (II) oder Formel (III) ersetzt ist, 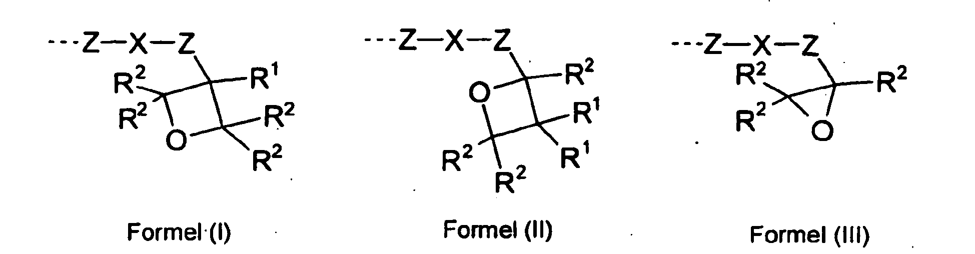 wobei gilt:
R¹ ist bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, ein aromatisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R¹ miteinander bzw. mit R², R³ und/oder R⁴ ein mono- oder polycyclisches, aliphatisches oder aromatisches Ringsystem bilden;
R² ist bei jedem Auftreten gleich oder verschieden Wasserstoff, eine geradkettige, verzweigte oder cyclische Alkylgruppe mit 1 bis 20 C-Atomen, ein aromatisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R² miteinander bzw. mit R¹, R³ und/oder R⁴ ein mono- oder polycyclisches, aliphatisches oder aromatisches Ringsystem bilden;
X ist bei jedem Auftreten gleich oder verschieden -O-, -S-, -CO-, -COO-, -O-CO- oder eine bivalente Gruppe -(CR³R⁴)ₙ-;
Z ist bei jedem Auftreten gleich oder verschieden eine bivalente Gruppe -(CR³R⁴)ₙ-;
R³, R⁴ ist bei jedem Auftreten gleich oder verschieden Wasserstoff, eine geradkettige, verzweigte oder cyclische Alkyl-, Alkoxy-, Alkoxyalkyl- oder Thioalkoxy-Gruppe mit 1 bis 20 C-Atomen, ein aromatisches oder heteroaromatisches Ringsystem mit 4 bis 24 aromatischen Ringatomen oder eine Alkenyl-Gruppe mit 2 bis 10 C-Atomen, bei denen ein oder mehrere Wasserstoffatome auch durch Halogen, wie Cl oder F, oder CN ersetzt sein können; dabei können auch zwei oder mehr Reste R³ bzw. R⁴ miteinander bzw. auch mit R¹ oder R² ein Ringsystem bilden,
n ist bei jedem Auftreten gleich oder verschieden eine ganze Zahl zwischen 0 und 20, bevorzugt zwischen 1 und 10, insbesondere zwischen 1 und 6;
mit der Maßgabe, dass die Anzahl dieser Gruppen gemäß Formel (I) bzw. Formel (II) bzw. Formel (III) durch die maximal verfügbaren, d. h. substituierbaren H-Atome begrenzt ist.

## Claims

1. Organic electronic device comprising cathode, anode, at least one layer of a conducting, doped polymer and at least one layer of an organic semiconductor, where acid-doped derivatives of polythiophene or polyaniline are used as conducting doped polymer, **characterised in that** at least one conducting or semiconducting cationically crosslinked polymeric buffer layer is introduced between the doped polymer and the organic semiconductor.

2. Organic electronic device according to Claim 1, **characterised in that** organic or polymeric light-emitting diodes (OLED, PLED), organic solar cells (O-SC), organic field-effect transistors (O-FET), organic thin-film transistors (O-TFT), organic integrated circuits (O-IC), organic field-quench elements (FQD), organic optical amplifiers or organic laser diodes (O-laser) are involved.

3. Organic electronic device according to Claim 1 and/or 2, **characterised in that** the organic semiconductor comprises at least one polymeric compound.

4. Organic electronic device according to Claim 3, **characterised in that** the polymeric compound is a conjugated polymer.

5. Organic electronic device according to Claim 4, **characterised in that** the organic semiconductor employed is a conjugated polymer from the classes of the poly-para-phenylenevinylenes (PPVs), polyfluorenes, polyspirobifluorenes, polydihydrophenanthrenes, polyindenofluorenes, systems based in the broadest sense on poly-p-phenylenes (PPPs), and derivatives of these structures.

6. Organic electronic device according to one or more of Claims 1 to 5, **characterised in that** the polymeric crosslinked buffer layer has a molecular weight in the range from 50 to 500 kg/mol before the crosslinking.

7. Organic electronic device according to one or more of Claims 1 to 6, **characterised in that** the layer thickness of the polymeric crosslinked buffer layer is in the range from 1 to 300 nm.

8. Organic electronic device according to one or more of Claims 1 to 7, **characterised in that** the buffer layer is built up from a conjugated polymer.

9. Organic electronic device according to one or more of Claims 1 to 8, **characterised in that** the materials of the buffer layer are triarylamine, thiophene or triarylphosphine polymers or combinations of these systems.

10. Organic electronic device according to one or more of Claims 1 to 9, **characterised in that** the materials of the buffer layer are copolymers of triarylamine, thiophene and/or triarylphosphine derivatives with fluorenes, spirobifluorenes, dihydrophenanthrenes and/or indenofluorenes.

11. Organic electronic device according to Claim 1, **characterised in that** the crosslinkable groups are selected from electron-rich olefin derivatives, heteronuclear multiple bonds with heteroatoms or heterogroups or rings containing heteroatoms which react by cationic ring-opening polymerisation.

12. Organic electronic device according to Claim 11, **characterised in that** at least one H atom in the materials of the buffer layer has been replaced by a heterocyclic compound which reacts by cationic ring-opening polymerisation.

13. Organic electronic device according to Claim 12, **characterised in that** at least one H atom in the materials of the buffer layer has been replaced by a group of the formula (I), formula (II) or formula (III), 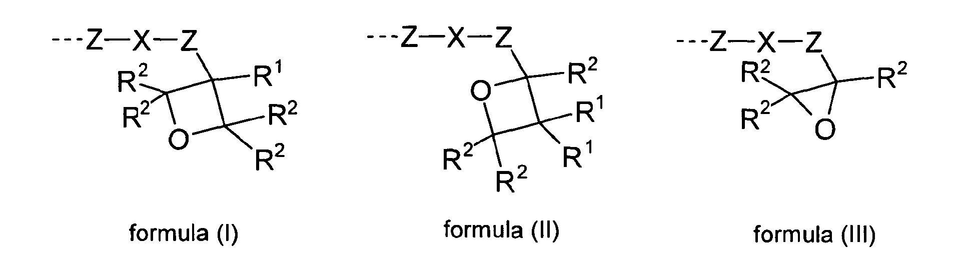 where:
R¹ is on each occurrence, identically or differently, hydrogen, a straight-chain, branched or cyclic alkyl, alkoxy or thioalkoxy group having 1 to 20 C atoms, an aromatic or heteroaromatic ring system having 4 to 24 aromatic ring atoms or an alkenyl group having 2 to 10 C atoms, in which one or more hydrogen atoms may be replaced by halogen, such as Cl and F, or CN, and one or more non-adjacent C atoms may be replaced by -O-, -S-, -CO-, -COO- or -O-CO-; a plurality of radicals R¹ here may also form a mono- or polycyclic, aliphatic or aromatic ring system with one another or with R², R³ and/or R⁴;
R² is on each occurrence, identically or differently, hydrogen, a straight-chain, branched or cyclic alkyl group having 1 to 20 C atoms, an aromatic or heteroaromatic ring system having 4 to 24 aromatic ring atoms or an alkenyl group having 2 to 10 C atoms, in which one or more hydrogen atoms may be replaced by halogen, such as Cl and F, or CN, and one or more non-adjacent C atoms may be replaced by -O-, -S-, -CO-, -COO- or -O-CO-; a plurality of radicals R² here may also form a mono- or polycyclic, aliphatic or aromatic ring system with one another or with R¹, R³ and/or R⁴;
X is on each occurrence, identically or differently, -O-, -S-, -CO-, -COO-, -O-CO- or a divalent group -(CR³R⁴)ₙ-;
Z is on each occurrence, identically or differently, a divalent group -(CR³R⁴)ₙ-;
R³, R⁴ are on each occurrence, identically or differently, hydrogen, a straight-chain, branched or cyclic alkyl, alkoxy, alkoxyalkyl or thioalkoxy group having 1 to 20 C atoms, an aromatic or heteroaromatic ring system having 4 to 24 aromatic ring atoms or an alkenyl group having 2 to 10 C atoms, in which one or more hydrogen atoms may also be replaced by halogen, such as Cl or F, or CN; two or more radicals R³ or R⁴ here may also form a ring system with one another or also with R¹ or R²;
n is on each occurrence, identically or differently, an integer between 0 and 20, preferably between 1 and 10, in particular between 1 and 6;
with the proviso that the number of these groups of the formula (I) or formula (II) or formula (III) is limited by the maximum number of available, i.e. substitutable, H atoms.

## Revendications

1. Dispositif électronique organique comprenant une cathode, une anode, au moins une couche d'un polymère dopé conducteur et au moins une couche d'un semiconducteur organique, dans lequel des dérivés dopés par acide de polythiophène ou polyaniline sont utilisés en tant que polymère dopé conducteur, **caractérisé en ce qu'**au moins une couche tampon polymérique réticulée cationiquement conductrice de semiconductrice est introduite entre le polymère dopé et le semiconducteur organique.

2. Dispositif électronique organique selon la revendication 1, **caractérisé en ce que** des diodes émettrices de lumière organiques ou polymériques (OLED, PLED), des cellules solaires organiques (O-SC), des transistors à effet de champ organiques (O-FET), des transistors à film mince organiques (O-TFT), des circuits intégrés organiques (O-IC), des éléments de modulation de champ organiques (FQD), des amplificateurs optiques organiques ou des diodes laser organiques (O-laser) sont concernés.

3. Dispositif électronique organique selon la revendication 1 et/ou 2, **caractérisé en ce que** le semiconducteur organique comprend au moins un composé polymérique.

4. Dispositif électronique organique selon la revendication 3, **caractérisé en ce que** le composé polymérique est un polymère conjugué.

5. Dispositif électronique organique selon la revendication 4, **caractérisé en ce que** semiconducteur organique utilisé est un polymère conjugué pris parmi les classes des poly-para-phénylènevinylènes (PPVs), des polyfluorènes, des polyspirobifluorènes, des polydihydrophénanthrènes, des polyindénofluorènes, des systèmes basés, dans un sens large, sur poly-p-phénylènes (PPPs) et des dérivés de ces structures.

6. Dispositif électronique organique selon une ou plusieurs des revendications 1 à 5, **caractérisé en ce que** la couche tampon réticulée polymérique a un poids moléculaire dans la plage de 50 à 500 kg/mol avant la réticulation.

7. Dispositif électronique organique selon une ou plusieurs des revendications 1 à 6, **caractérisé en ce que** l'épaisseur de couche de la couche tampon réticulée polymérique est dans la plage de 1 à 300 nm.

8. Dispositif électronique organique selon une ou plusieurs des revendications 1 à 7, **caractérisé en ce que** la couche tampon est élaborée à partir d'un polymère conjugué.

9. Dispositif électronique organique selon une ou plusieurs des revendications 1 à 8, **caractérisé en ce que** les matériaux de la couche tampon sont des polymère triarylamine, thiophène ou triarylphosphine ou des combinaisons de ces systèmes.

10. Dispositif électronique organique selon une ou plusieurs des revendications 1 à 9, **caractérisé en ce que** les matériaux de la couche tampon sont des copolymères de dérivés de triarylamine, thiophène et/ou triarylphosphine avec des fluorènes, spirobifluorènes, dihydrophénanthrènes et/ou indénofluorènes.

11. Dispositif électronique organique selon la revendication 1, **caractérisé en ce que** les groupes polymérisables sont choisis parmi des dérivés oléfine riches en électrons, de multiples liaisons hétéronucléaires avec des hétéroatomes ou des hétérogroupes ou des cycles contenant des hétéroatomes qui réagissent par polymérisation en cycle ouvert cationique.

12. Dispositif électronique organique selon la revendication 11, **caractérisé en ce qu'**au moins un atome de H dans les matériaux de la couche tampon a été remplacé par un composé hétérocyclique qui réagit par polymérisation en cycle ouvert cationique.

13. Dispositif électronique organique selon la revendication 12, **caractérisé en ce qu'**au moins un atome de H dans les matériaux de la couche tampon a été remplacé par un groupe de la formule (I), la formule (II) ou la formule (III), 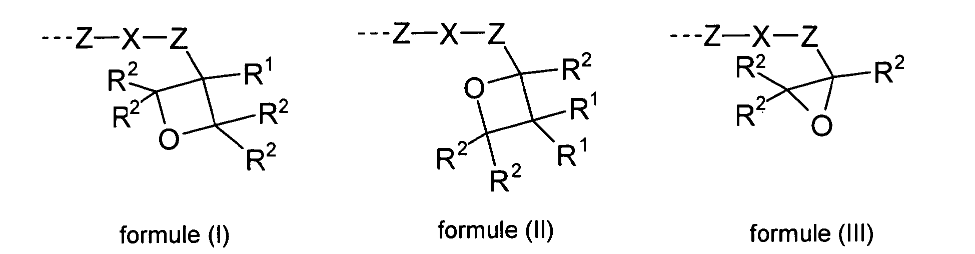 dans lesquelles :
R¹ est à chaque occurrence, de façon identique ou différente hydrogène, un groupe alkyle, alcoxy ou thioalcoxy en chaîne droite, ramifié ou cyclique ayant 1 à 20 atomes de C, un système de cycle aromatique ou hétéroaromatique ayant 4 à 24 atomes de cycle aromatique ou un groupe alkényle ayant 2 à 10 atomes de C, dans lequel un ou plusieurs atomes d'hydrogène peuvent être remplacés par un halogène tel que Cl et F, ou CN, et un ou plusieurs atomes de C non adjacents peuvent être remplacés par -O-, -S-, -CO-, -COO- ou -O-CO- ; une pluralité de radicaux R¹ peuvent ici également former un système de cycle aliphatique ou aromatique, mono- ou polycyclique avec un autre ou avec R², R³ et/ou R⁴ ;
R² est à chaque occurrence, de façon identique ou différente hydrogène, un groupe alkyle en chaîne droite, ramifié ou cyclique ayant 1 à 20 atomes de C, un système de cycle aromatique ou hétéroaromatique ayant 4 à 24 atomes de cycle aromatique ou un groupe alkényle ayant 2 à 10 atomes de C, dans lequel un ou plusieurs atomes d'hydrogène peuvent être remplacés par un halogène tel que Cl et F, ou CN, et un ou plusieurs atomes de C non adjacents peuvent être remplacés par -O-, -S-, -CO-, -COO- ou -O-CO- ; une pluralité de radicaux R² peuvent ici également former un système de cycle aliphatique ou aromatique, mono- ou polycyclique avec un autre ou avec R¹, R³ et/ou R⁴ ;
X est à chaque occurrence, de façon identique ou différente -O-, -S-, -CO-, -COO- ou -O-CO- ou un groupe divalent -(CR³R₄)ₙ- ;
Z est à chaque occurrence, de façon identique ou différente un groupe divalent -(CR³R⁴)ₙ- ;
R³, R⁴ sont à chaque occurrence, de façon identique ou différente hydrogène, un groupe alkyle, alcoxy, alcoxyalkyle ou thioalcoxy en chaîne droite, ramifié ou cyclique ayant 1 à 20 atomes de C, un système de cycle aromatique ou hétéroaromatique ayant 4 à 24 atomes de cycle aromatique ou un groupe alkényle ayant 2 à 10 atomes de C, dans lequel un ou plusieurs atomes d'hydrogène peuvent être remplacés par un halogène tel que Cl ou F, ou CN, deux ou plus de deux radicaux R³ ou R⁴ peuvent ici également former un système de cycle avec un autre ou avec R¹ ou R² ;
n est à chaque occurrence, de façon identique ou différente, un entier entre 0 et 20, de préférence entre 1 et 10, en particulier entre 1 et 6 ;
étant entendu que le nombre de ces groupes de la formule (I) ou la formule (II) ou la formule (III) est limité par le nombre maximum d'atomes de H disponibles, c'est-à-dire substituables.
